# EUROPÄISCHE PATENTSCHRIFT

(11) **EP 1 295 340 B1**
(45) Veröffentlichungstag und Bekanntmachung des Hinweises auf die Patenterteilung: **15.08.2007**
(21) Anmeldenummer: 01951372.0
(22) Anmeldetag: 12.06.2001
(51) Int. Cl.: H01L 25/065

(54) **HALBLEITER-CHIP**
SEMICONDUCTOR CHIP
PUCE A SEMI-CONDUCTEUR

(30) Priorität: 30.06.2000 DE 10030994
(43) Veröffentlichungstag der Anmeldung: 26.03.2003
(73) Patentinhaber: Infineon Technologies AG, 81669 München (DE)
(72) Erfinder: MAYER, Albrecht, 82041 Deisenhofen (DE); WENZEL, Andreas, 81373 München (DE)
(74) Vertreter: Repkow, Ines
(86) Internationale Anmeldenummer: PCT/DE2001/002174
(87) Internationale Veröffentlichungsnummer: WO 2002/003464

(56) Entgegenhaltungen:
- EP-A- 0 486 829
- EP-A- 0 766 311
- EP-A- 0 905 779
- US-A- 5 767 009
- PATENT ABSTRACTS OF JAPAN vol. 014, no. 142 (E-0904), 16. März 1990 (1990-03-16) & JP 02 005455 A (HITACHI LTD), 10. Januar 1990 (1990-01-10)
- SCHMITT W: "NEXUS - Debug-Konzept der Zukunft? Universelle Emulations- und Kalibrierschnittstelle für Mikrocontroller" ELEKTRONIK, FRANZIS VERLAG GMBH. MÜNCHEN, DE, Bd. 48, Nr. 17, 24. August 1999 (1999-08-24), Seiten 52-59, XP000931028 ISSN: 0013-5658

## Beschreibung

Die vorliegende Erfindung betrifft eine Vorrichtung gemäß dem Oberbegriff des Patentanspruchs 1, d.h. einen Halbleiter-Chip mit Kontaktstellen zur Verbindung des Halbleiter-Chips mit anderen Komponenten eines den Halbleiter-Chip enthaltenden Systems.

Solche Halbleiter-Chips sind seit vielen Jahren in unzähligen Ausführungsformen bekannt.

Halbleiter-Chips weisen vor allem aufgrund der immer größer werdenden Komplexität und der immer höheren Geschwindigkeit, mit welcher diese arbeiten, das Problem auf, daß die Benutzer der Halbleiter-Chips, genauer gesagt die Benutzer der die Halbleiter-Chips enthaltende Bauteile häufig nicht mehr in der Lage sind, die Ursachen für eine nicht ordnungsgemäße Funktion der Halbleiter-Chips und/oder der die Halbleiter-Chips enthaltenden Systeme zu erkennen und zu beheben.

Für besonders komplexe Halbleiter-Chips wie beispielsweise Mikroprozessoren und Mikrocontroller wurden daher sogenannte Emulatoren entwickelt, mit Hilfe welcher sich während des normalen Betriebes des Halbleiter-Chips interne Zustände und Abläufe im Halbleiter-Chip (beispielsweise Registerinhalte, Speicherinhalte, und/oder über interne oder externe Leitungen oder Busse übertragene Adressen, Daten, Steuersignale etc.) beobachten und wunschgemäß verändern lassen.

Bei der Emulation eines Halbleiter-Chips wird dieser (das diesen enthaltende Bauteil) im allgemeinen aus dem diesen enthaltenden System entfernt und durch eine spezielle Schaltung ersetzt, wobei diese spezielle Schaltung den zu testenden Halbleiter-Chip selbst (wenn der aus dem System entnommene Halbleiter-Chip in die spezielle Schaltung eingesetzt wird) oder eine besondere Ausführungsform des Halbleiter-Chips (eine sogenannte Bond-Out-Version, welche zusätzliche Anschlüsse zur Beobachtung interner Zustände oder Vorgänge aufweist) enthält.

Eine solche Emulation weist eine ganze Reihe von Nachteilen auf.

Einer der Nachteile besteht darin, daß das Entnehmen des Halbleiter-Chips aus dem System und das Ersetzen desselben durch eine wie auch immer geartete Schaltung entweder überhaupt nicht möglich ist (beispielsweise wenn der zu emulierende Halbleiter-Chip eingelötet oder schlecht zugänglich oder von einem Abschirmkäfig umgeben ist), oder aber zumindest sehr aufwendig ist.

Ein weiterer Nachteil besteht darin, daß sich das System während der Emulation des zu emulierenden Halbleiter-Chips aufgrund der hierfür erforderlichen Veränderungen häufig nicht mehr exakt so wie im normalen Betrieb verhält. Dies hat zwei Ursachen: einerseits, weil der zu emulierende Halbleiter-Chip durch eine spezielle Schaltung ersetzt wird, und andererseits, weil die spezielle Schaltung meistens nicht mehr den zu emulierenden Halbleiter-Chip selbst, sondern eine besondere Version (die bereits erwähnte Bond-Out-Version) des Halbleiter-Chips enthält.

Darüber hinaus sind die Entwicklung und Herstellung einer Bond-Out-Version von Halbleiter-Chips sehr aufwendig und teuer. Ferner kommen Bond-Out-Versionen häufig erst später auf den Markt als die Standard-Versionen der Halbleiter-Chips.

Zur Vermeidung dieser Nachteile behilft man sich mittlerweile damit, daß man insbesondere komplexere Halbleiter-Chips standardmäßig mit einem sogenannten On Chip Debug Support (OCDS) ausstattet. Die Integration eines OCDS-Moduls in den Halbleiter-Chip macht diesen jedoch erheblich größer und teurer als es ohne OCDS-Modul der Fall wäre und läuft dem Bestreben, Halbleitpr-Chips immer noch kleiner und noch billiger herzustellen, entgegen. Dies ist besonders schmerzlich, weil Halbleiter-Chips mit OCDS-Modul im allgemeinen nicht ohne OCDS-Modul angeboten werden, und weil das OCDS-Modul eines Halbleiter-Chips allenfalls für die Systementwicklung, nicht aber für den normalen Betrieb des Halbleiter-Chips benötigt werden.

Diese Nachteile sind noch ausgeprägter, wenn man ein sogenanntes NEXUS-Modul in den Halbleiter-Chip integriert.

Das Dokument EP 0 905 779 A offenbart einen Chipstapel mit einem zu emulierenden ersten Halbleiter-Chip und einem Ausgabechip, auf welchen der erste Halbleiter-Chip aufgesetzt ist. Der erste Halbleiterchip weist dabei Kontaktstellen auf zur Herstellung einer Verbindung mit dem Ausgabechip, der Komponenten für die Emulierung des ersten Halbleiter-Chips enthält. Der Ausgabechip ist flächenmäßig größer als der erste Halbleiter-Chip.

Der vorliegenden Erfindung liegt daher die Aufgabe zugrunde, einen Halbleiter-Chip zu entwickeln, der sich klein und billig realisieren und mit minimalem Aufwand und ohne Veränderung der Eigenschaften des den Halbleiter-Chip enthaltenden Systems emulieren läßt.

Diese Aufgabe wird erfindungsgemäß durch den in Patentanspruch 1 beanspruchten Halbleiter-Chip gelöst.

Der erfindungsgemäße Halbleiter-Chip zeichnet sich dadurch aus, daß ein Teil der Kontaktstellen zur Verbindung des Halbleiter-Chips mit anderen Komponenten eines den Halbleiter-Chip enthaltenden Systems zur Herstellung einer Verbindung mit einem auf den Halbleiter-Chip aufgesetzten zweiten Halbleiter-Chip vorgesehen ist, wobei der

zweite Halbleiter-Chip Komponenten für eine Emulation des ersten Halbleiter-Chips enthält, umfassend eine Breakpoint-Logik, eine Watchpoint-Logik, einem Trace-Speicher, eine Kompressions einheit und/oder einem zusätzlichen Speicher, welcher einen im ersten Halbleiter-Chip verhandenen Speicher ersetzen kann, und wobei die Steuerung des zweiten Halbleiter-Chips, das Einschreiben von Daten in dem zweiten Halbleiter-Chips, und das Auslesen von Daten aus dem zweiten Halbleiter-Chip über Kontaktstellen des ersten Halbleiter-Chips erfolgt über welche dieser mit Ein- und/oder Ausgabeanschlüssen eines den ersten Halbleiter-Chip enthaltenden Bauteils verbunden ist. So kann aus einem nicht emulierbaren Halbleiter-Chip einfach durch Aufsetzen des zweiten Halbleiter-Chips ein emulierbarer Halbleiter-Chip gemacht werden.

Dies eröffnet die Möglichkeit, daß der zu emulierende Halbleiter-Chip der emulierbaren Bauteil-Version genau der Halbleiter-Chip ist, der auch in der nicht emulierbaren Standard-Version des Bauteils verwendet wird. Dadurch
- verringert sich der zur Entwicklung und Herstellung einer emulierbaren Bauteil-Version erforderliche Aufwand, und
- kann gewährleistet werden, daß sich die emulierbare Bauteil-Version und die nicht emulierbare Standard-Version des Bauteils unter allen Umständen exakt gleich verhalten.

Bei entsprechender Ausbildung des zweiten Halbleiter-Chips entfällt sogar die Notwendigkeit, den zu emulierenden Halbleiter-Chip zum Emulieren aus dem diesen enthaltenden System zu entnehmen und durch eine spezielle Schaltung zu ersetzen.

Der beanspruchte Halbleiter-Chip läßt sich nach alledem klein und billig realisieren und mit minimalem Aufwand und ohne Veränderung der Eigenschaften des den Halbleiter-Chip enthaltenden Systems emulieren.

Vorteilhafte Weiterbildungen der Erfindung sind den Unteransprüchen, der nachfolgenden Beschreibung und den Figuren entnehmbar.

Die Erfindung wird nachfolgend anhand eines Ausführungsbeispiels unter Bezugnahme auf die Figuren näher beschrieben. Es zeigen
- Figur 1: eine Draufsicht auf den nachfolgend näher beschriebenen ersten Halbleiter-Chip, und
- Figur 2: eine perspektivische Ansicht des Zustandes, in welchem der in Figur 1 gezeigte Halbleiter-Chip mit einem darauf aufgesetzten zweiten Halbleiter-Chip verbunden ist.

Bei dem im folgenden beschriebenen Halbleiter-Chip handelt es sich um einen Mikroprozessor oder Mikrocontroller.

Der beschriebene Halbleiter-Chip zeichnet sich dadurch aus, daß ein Teil seiner Kontaktstellen zur Verbindung des Halbleiter-Chips mit anderen Komponenten eines den HalbleiterChip enthaltenden Systems zur Herstellung einer Verbindung mit einem auf den Halbleiter-Chip aufsetzbaren und diesen Funktions- und/oder leistungsmäßig erweiternden zweiten Halbleiter-Chip vorgesehen ist.

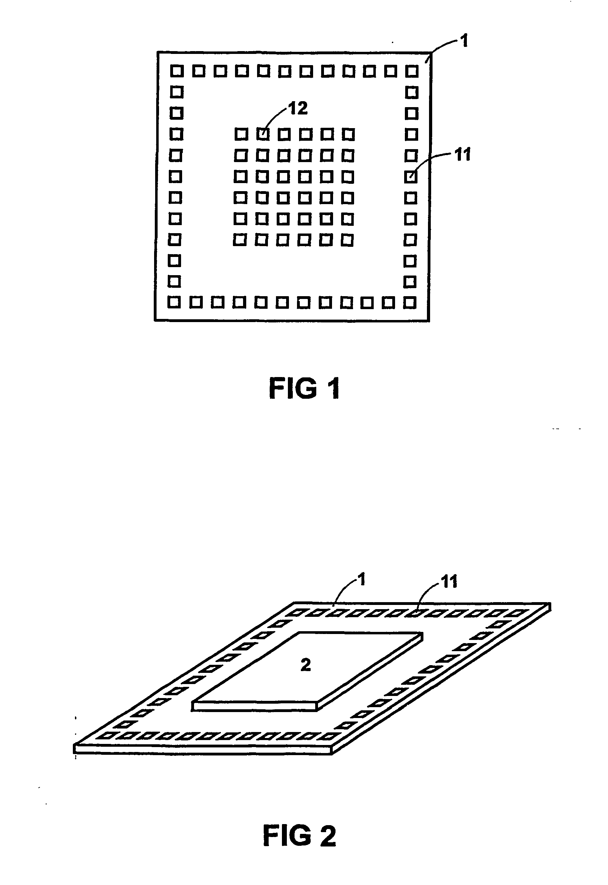

Figur 1 zeigt eine Draufsicht auf die Kontaktstellen des Halbleiter-Chips, genauer gesagt auf die mit den Kontaktstellen versehene Seite des Halbleiter-Chips.

Wie aus der Figur 1 ersichtlich ist, weist der mit dem Bezugszeichen 1 bezeichnete Halbleiter-Chip eine Vielzahl von entlang des Randes des Halbleiter-Chips angeordneten Kontaktstellen 11 und eine Vielzahl von im zentralen Bereich des Halbleiter-Chips angeordneten Kontaktstellen 12 auf.

Sowohl die Kontaktstellen 11 als auch die Kontaktstellen 12 dienen zur Verbindung des Halbleiter-Chips mit anderen Komponenten eines den Halbleiter-Chip enthaltenden Systems.

Die Kontaktstellen 11 werden mit den Ein- und/oder Ausgabeanschlüssen des den Halbleiter-Chip enthaltenden Bauteils verbunden ; es handelt sich um sogenannte Pads, die so beschaffen sind, daß sie über Bond-Drähte mit den Ein- und/oder Ausgabeanschlüssen des den Halbleiter-Chip enthaltenden Bauteils verbunden werden können.

Die Kontaktstellen 12 sind zur Herstellung einer Verbindung mit einem auf den Halbleiter-Chip aufsetzbaren zweiten Halbleiter-Chip vorgesehen; es handelt sich um Pads, die es gestatten, daß der zweite Halbleiter-Chip, genauer gesagt zugeordnete Pads desselben unter Verwendung der sogenannten Flip-Chip-Technologie mit dem ersten Halbleiter-Chipiverbunden werden.

Der Zustand, in welchem der zweite Halbleiter-Chip auf den ersten Halbleiter-Chip aufgesetzt und mit diesem über die Kontaktstellen 12 verbunden ist, ist in Figur 2 veranschaulicht; der zweite Halbleiter-Chip ist dabei mit dem Bezugszeichen 2 bezeichnet.

Wie aus der Figur 2 ersichtlich ist, ist der zweite Halbleiter-Chip 2 wesentlich kleiner als der erste Halbleiter-Chip 1, so daß nach dem Aufsetzen des zweiten Halbleiter-Chips 2 auf den ersten Halbleiter-Chip 1 die Kontaktelemente 11 des ersten Halbleiter-Chips 1 nicht bedeckt werden und frei zugänglich sind.

Die Kontaktstellen 11 des ersten Halbleiter-Chips werden, wie vorstehend bereits erwähnt wurde, über Bonddrähte mit den Ein- und/oder Ausgabeanschlüssen eines die Halbleiter-Chips enthaltenden Bauteils verbunden.

Der zweite Halbleiter-Chip 2 hat neben den Kontaktstellen, die er aufweisen muß, um mit dem ersten Halbleiter-Chip 1 verbunden zu werden, keine weiteren Kontaktstellen und muß nicht mit den Ein- und/oder Ausgabeanschlüssen eines die Halbleiter-Chips enthaltenden Bauteils verbunden werden. Falls es notwendig ist, den zweiten Halbleiter-Chip 2 von außerhalb des die Halbleiter-Chips enthaltenden Bauteils anzusprechen, erfolgt dies über die Kontaktstellen 11 des ersten Halbleiter-Chips 1, den ersten Halbleiter-Chip 1 und die Kontaktstellen 12 des ersten Halbleiter-Chips 1. Die Kontaktstellen 11 des ersten Halbleiter-Chips 1 umfassen alle Anschlüsse, die notwendig sind, um sowohl den ersten Halbleiter-Chip 1 als auch den zweiten Halbleiter-Chip 2 wunschgemäß betreiben zu können.

Im betrachteten Beispiel ist der erste Halbleiter-Chip 1 der den Benutzer eigentlich interessierende Chip, beispielsweise, der Mikroprozessor oder den Mikrocontroller, den der Benutzer einsetzen will. Der zweite Halbleiter-Chip ist ein optionaler Zusatz, der zur Erweiterung der Funktionalität und/oder der Leistungsfähigkeit des ersten Halbleiter-Chips 1 dient. D.h., der erste Halbleiter-Chip 1 kann wahlweise alleine oder in Kombination mit dem zweiten Halbleiter-Chip verwendet werden.

Erfindungsgemäß enthält der zweite Halbleiter-Chip 2 Komponenten, für eine Emulation des ersten Halbleiter-Chips 1, beispielsweise
- eine im allgemeinen als Breakpoint-Logik oder Watchpoint-Logik bezeichnete Logik zur Einstellung und der Überwachung des Erreichens bestimmter Bedingungen (beispielsweise des Zugriffs auf eine bestimmte Adresse, des Lesens und/oder Schreibens und/oder der Verwendung bestimmter Daten, der Ausführung eines bestimmten Befehls, des Auftreten eines bestimmten Steuersignals, etc.),
- einen sogenannten Trace-Speicher, in welchem fortlaufend interessierende Speicher- oder Registerinhalte, Daten, Adressen und/oder Steuersignale, die innerhalb eines definierbaren Zeitfensters auftreten, gespeichert werden,
- eine Kompressioneinheit zur Komprimierung der in den Trace-Speicher einzuschreibenden und/oder der aus dem Trace-Speicher auszugebenden Daten, und/oder
- zusätzliche Speicher, welche bei Bedarf im ersten Halbleiter-Chip enthaltene Festspeicher (ROMs) oder Speicher, deren Inhalt nur aufwendig zu verändern ist (Flash-Speicher, EPROMS, EEPROMS, etc.), ersetzen können.

Der Aufbau und der Inhalt der Halbleiter-Chips gestatten es, unter Verwendung von ein und dem selben Halbleiter-Chip (unter Verwendung des den Benutzer eigentlich interessierenden ersten Halbleiter-Chips 1) zwei verschiedene Bauteil-Versionen herzustellen, nämlich
- eine "nur" den ersten Halbleiter-Chip 1 enthaltende, also nicht emulierbare Standard-Version, und
- eine den ersten Halbleiter-Chip 1 und den zweiten Halbleiter-Chip 2 enthaltende, also emulierbare Emulator-Version.

Dadurch, daß der erste Halbleiter-Chip 1 aufgrund der Kombinierbarkeit mit dem zweiten Halbleiter-Chip 2 keine ein Debuggen oder Emulieren des ersten Halbleiter-Chips 1 ermöglichende Komponenten aufweisen muß, kann er sehr klein hergestellt werden. Daß der erste Halbleiter-Chip 1 zusätzliche Kontaktstellen 11 zur Steuerung des zweiten Halbleiter-Chips 2, zum Einschreiben von Daten in den zweiten Halbleiter-Chip 2, und/oder zum Auslesen von Daten aus dem zweiten Halbleiter-Chip 2 aufweisen muß, macht den ersten Halbleiter-Chip 1 nicht oder nur unwesentlich größer und teurer als er ohne diese Anschlüsse wäre. Hierfür müssen nämlich nur einige wenige zusätzliche Anschlüsse vorgesehen werden, beispielsweise eine JTAG-Schnittstelle, wie sie teilweise auch zum Ansprechen von OCDS-Modulen verwendet wird, oder eine (vorzugsweise schmale) NEXUS-Schnittstelle. Unter Umständen kann zum Ansprechen des zweiten Halbleiter-Chips 2 sogar eine Schnittstelle verwendet werden, die der erste Halbleitir-Chip 1 ohnehin aufweisen muß und/oder die auch für andere Zwecke als zum Ansprechen des zweiten Halbleiter-Chips 2 verwendbar ist oder verwendet wird.

Die geringe Größe des ersten Halbleiter-Chips 1 ermöglicht es, daß auch das diesen enthaltende Standard-Bauteil sehr klein und billig herstellbar ist. Damit wird dem Bedürfnis nach Bauteilen entsprochen, die nicht größer und/oder teurer sind, als es für den normalen Einsatz (den Einsatz im fertig entwickelten und fehlerfrei arbeitenden System) unbedingt erforderlich ist.

Der vorstehend beschriebene Aufbau des ersten Halbleiter-Chips 1 und dessen geringe Größe ermöglichen es ferner, daß auch die Emulator-Version des den ersten Halbleiter-Chip enthaltenden Bauteils sehr klein und billig herstellbar ist.

Die Emulator-Version des den ersten Halbleiter-Chip enthaltenden Bauteils ist nicht einmal größer als die Standard-Version.

Da der in diesem Fall auf den ersten Halbleiter-Chip 1 aufgesetzte zweite Halbleiter-Chip 2 eine kleinere Fläche hat als der erste Halbleiter-Chip 1 und diesen seitlich nicht überragt, wird die Fläche, die die Emulator-Version des Bauteils aufweist, nicht größer als die Fläche der Standard-Version.

Die Emulator-Version ist aber auch nicht höher als die Standard-Version; der (direkt auf den ersten Halbleiter Chip 1 aufgesetzte) zweite Halbleiter-Chip 2 ist nämlich nicht oder allenfalls unwesentlich höher als die Schlingen der Bonddrähte, mittels welcher die Kontaktstellen 11 des ersten Halbleiter-Chips 1 mit den Ein- und/oder Ausgabeanschlüssen des den ersten Halbleiter-Chip 1 oder ersten Halbleiter-Chip 1 und zweiten Halbleiter-Chip 2 enthaltenden Bauteils verbunden werden.

Damit kann für die Standard-Version und für die Emulator-Version des den ersten Halbleiter-Chip 1 enthaltenden Bauteils das selbe Gehäuse verwendet werden.

Die Emulator-Version des Bauteils zeichnet sich ferner dadurch aus, daß der zu emulierende Teil desselben, nämlich der erste Halbleiter-Chip 1 desselben exakt den Aufbau aufweist wie der in der Standard-Version des Bauteils eingesetzte Halbleiter-Chip; die Emulator-Version und die Standard-Version des Bauteils verhalten sich dadurch unter allen Umständen bis ins letzte Detail vollkommen identisch.

Die Verbindung zwischen den ersten Halbleiter-Chip 1 und zweiten Halbleiter-Chip 2 erfolgt vorzugsweise eine definierte Standard-Schnittstelle, mit der alle Halbleiter-Chips ausgestattet werden, bei denen ein Bedarf bestehen könnte, den betreffenden Halbleiter-Chip zu emulieren. Dann kann der zweite Halbleiter-Chip 2 mit beliebigen ersten Halbleiter-Chips kombiniert werden und muß nicht für jeden Halbleiter-Chip neu entwickelt werden.

Der bereits erwähnte Trace-Speicher, den der zweite Halbleiter-Chip 2 vorzugsweise enthält, ist im betrachteten Beispiel als zirkulärer Puffer ausgebildet und
- zeichnet permanent vorzugsweise (beispielsweise unter Verwendung eines Multiplexers) auswählbare Daten, Adressen, und/oder Steuersignale auf,
- unterbricht (vorzugsweise mit einem einstellbaren Nachlauf) die Aufzeichnung bei Erreichen eines eingestellten Breakpoints oder Watchpoints, und
- ist bei Bedarf seriell über die bereits erwähnte JTAG-Schnittstelle oder die ebenfalls bereits erwähnte NEXUS-Schnittstelle oder eine sonstige Schnittstelle auslesbar.

### Bezugszeichenliste

- 1: erster Halbleiter-Chip
- 2: zweiter Halbleiter-Chip
- 11, 12: Kontaktstellen von 1

## Patentansprüche

1. Halbleiter-Chip mit Kontaktstellen (11, 12) zur Verbindung des Halbleiter-Chips (1) mit anderen Komponenten eines den Halbleiter-Chip enthaltenden Systems, wobei ein Teil der Kontaktstellen (12) zur Herstellung einer Verbindung mit einem auf den Halbleiter-Chip (1) aufgesetzten zweiten Halbleiter-Chip (2) vorgesehen ist,
**dadurch gekennzeichnet,**
- **daß** der zweite Halbleiter-Chip (2) Komponenten für eine Emulierung des ersten Halbleiter-Chips (1) enthält, wobei diese Komponenten eine Breakpoint-Logik, eine Watchpoint-Logik, einen Trace-Speicher, eine Kompressioneinheit und/oder einen zusätzlichen Speicher, welcher einen im ersten Halbleiter-Chip vorhandenen Speicher ersetzen kann, umfassen, und
- **daß** die Steuerung des zweiten Halbleiter-Chips (2), das Einschreiben von Daten in den zweiten Halbleiter-Chip (2), und das Auslesen von Daten aus dem zweiten Halbleiter-Chip (2) über Kontaktstellen (11) des ersten Halbleiter-Chips (1) erfolgt, über welche dieser mit Ein- und/oder Ausgabeanschlüssen eines den ersten Halbleiter-Chip enthaltenden Bauteils verbunden ist.

2. Halbleiter-Chip nach Anspruch 1,
**dadurch gekennzeichnet,**
**daß** die Steuerung des zweiten Halbleiter-Chips (2), das Einschreiben von Daten in den zweiten Halbleiter-Chip (2), und
das Auslesen von Daten aus dem zweiten Halbleiter-Chip (2) über eine auch für andere Zwecke benutzbare JTAG-Schnittstelle erfolgt.

3. Halbleiter-Chip nach Anspruch 1,
**dadurch gekennzeichnet,**
**daß** die Steuerung des zweiten Halbleiter-Chips (2), das Einschreiben von Daten in den zweiten Halbleiter-Chip (2), und das Auslesen von Daten aus dem zweiten Halbleiter-Chip (2) über eine NEXUS-Schnittstelle erfolgt.

4. Halbleiter-Chip nach einem der vorhergehenden Ansprüche,
**dadurch gekennzeichnet,**
**daß** der zweite Halbleiter-Chip (2) außer den Kontaktstellen, über welche er mit dem ersten Halbleiter-Chip (1) verbunden ist, keine weiteren Kontaktstellen aufweist.

5. Halbleiter-Chip nach einem der vorhergehenden Ansprüche,
**dadurch gekennzeichnet,**
**daß** der zweite Halbleiter-Chip (2) eine kleinere Fläche aufweist als der erste Halbleiter-Chip (1).

6. Halbleiter-Chip nach einem der vorhergehenden Ansprüche,
**dadurch gekennzeichnet,**
**daß** der zweite Halbleiter-Chip (2) unter Verwendung der Flip-Chip-Technik auf den ersten Halbleiter-Chip (1) montiert wird.

7. Halbleiter-Chip nach einem der vorhergehenden Ansprüche,
**dadurch gekennzeichnet,**
**daß** sich der erste Halbleiter-Chip (1) mit dem darauf aufgesetzten zweiten Halbleiter-Chip (2) genau so verhält wie ohne den zweiten Halbleiter-Chip (2).

## Claims

1. Semiconductor chip with contact points (11, 12) for connecting the semiconductor chip (1) to other components of a system containing the semiconductor chip, in which a part of the contact points (12) is provided for producing a connection to a second semiconductor chip (2), which is placed onto the semiconductor chip (1),
**characterized**
- **in that** the second semiconductor chip (2) contains components (1) for an emulation of the first semiconductor chip these components comprising a breakpoint logic, a watchpoint logic, a trace memory, a compression unit and/or an additional memory, which can replace a memory which is present in the first semiconductor chip and
- **in that** the control of the second semiconductor chip (2), the writing of data to the second semiconductor chip (2) and the reading of data from the second semiconductor chip (2) are effected via contact points (11) of the first semiconductor chip (1), via which said first semiconductor chip is connected to input and/or output terminals of a device containing the first semiconductor chip.

2. Semiconductor chip according to Claim 1,
**characterized**
**in that** the control of the second semiconductor chip (2), the writing of data to the second semiconductor chip (2) and the reading of data from the second semiconductor chip (2) are effected via a JTAG interface which can also be used for other purposes.

3. Semiconductor chip according to Claim 1,
**characterized**
**in that** the control of the second semiconductor chip (2), the writing of data to the second semiconductor chip (2) and the reading of data from the second semiconductor chip (2) are effected via a NEXUS interface.

4. Semiconductor chip according to one of the preceding claims,
**characterized**
**in that** the second semiconductor chip (2) has no further contact points besides the contact points via which it is connected to the first semiconductor chip (1).

5. Semiconductor chip according to one of the preceding claims,
**characterized**
**in that** the second semiconductor chip (2) has a smaller area than the first semiconductor chip (1).

6. Semiconductor chip according to one of the preceding claims,
**characterized**
**in that** the second semiconductor chip (2) is mounted onto the first semiconductor chip (1) using flip-chip technology.

7. Semiconductor chip according to one of the preceding claims,
**characterized**
**in that** the first semiconductor chip (1) behaves exactly the same with the second semiconductor chip (2) placed on it as without the second semiconductor chip (2).

## Revendications

1. Puce en semiconducteur comprenant des points de contact (11, 12) pour relier la puce en semiconducteur (1) avec d'autres composants d'un système contenant la puce en semiconducteur, une partie des points de contact (12) étant prévue pour établir une liaison avec une deuxième puce en semiconducteur (2) montée sur la puce en semiconducteur (1),
**caractérisée en ce**
- **que** la deuxième puce en semiconducteur (2) comprend des composants pour une émulation de la première puce en semiconducteur (1), ces composants incluant une logique de breakpoint, une logique de watchpoint, une mémoire de trace, une unité de compression et/ou une mémoire supplémentaire qui peut remplacer une mémoire présente dans la première puce en semiconducteur et
- **que** la commande de la deuxième puce en semiconducteur (2), l'écriture de données dans la deuxième puce en semiconducteur (2) et la lecture de données depuis la deuxième puce en semiconducteur (2) s'effectuent par le biais de points de contact (11) de la première puce en semiconducteur (1) par le biais desquels celle-ci est reliée avec les bornes d'entrée et/ou de sortie d'un composant contenant la première puce en semiconducteur.

2. Puce en semiconducteur selon la revendication 1, **caractérisée en ce que** la commande de la deuxième puce en semiconducteur (2), l'écriture de données dans la deuxième puce en semiconducteur (2) et la lecture de données depuis la deuxième puce en semiconducteur (2) s'effectuent par le biais le biais d'une interface JTAG également utilisable à d'autres fins.

3. Puce en semiconducteur selon la revendication 1, **caractérisée en ce que** la commande de la deuxième puce en semiconducteur (2), l'écriture de données dans la deuxième puce en semiconducteur (2) et la lecture de données depuis la deuxième puce en semiconducteur (2) s'effectuent par le biais d'une interface NEXUS.

4. Puce en semiconducteur selon l'une des revendications précédentes, **caractérisée en ce que** la deuxième puce en semiconducteur (2) ne présente aucun point de contact autre que les points de contact par le biais desquels elle est reliée avec la première puce en semiconducteur (1).

5. Puce en semiconducteur selon l'une des revendications précédentes, **caractérisée en ce que** la deuxième puce en semiconducteur (2) présente une surface plus petite que la première puce en semiconducteur (1).

6. Puce en semiconducteur selon l'une des revendications précédentes, **caractérisée en ce que** la deuxième puce en semiconducteur (2) est montée sur la première puce en semiconducteur (1) en employant la technique Flip-Chip.

7. Puce en semiconducteur selon l'une des revendications précédentes, **caractérisée en ce que** la première puce en semiconducteur (1) sur laquelle est montée la deuxième puce en semiconducteur (2) se comporte exactement de la même manière que sans la deuxième puce en semiconducteur (2).
